**Europäisches Patentamt**

**European Patent Office**

**Office européen des brevets**

(19)

(11) Veröffentlichungsnummer: **0 657 733 A2**

## (12) EUROPÄISCHE PATENTANMELDUNG

(21) Anmeldenummer: **94250274.1**

(22) Anmeldetag: **14.11.94**

(51) Int. Cl.6: **G01N 27/22**, G01N 27/00, G01N 22/00

(30) Priorität: **08.12.93 DE 4342505**

(43) Veröffentlichungstag der Anmeldung:
**14.06.95 Patentblatt 95/24**

(84) Benannte Vertragsstaaten:
**AT CH DE FR GB IT LI NL**

(71) Anmelder: **Stange, Gerd, Prof. Dr.-Ing.**
**Kronkamp 39**
**D-24589 Nortorf (DE)**
Anmelder: **NU-TECH GmbH**

Ilsahl 5
**D-24536 Neumünster (DE)**

(72) Erfinder: **Stange, Gerd, Dr.**
**Kronkamp 39**
**D-24589 Nortorf (DE)**

(74) Vertreter: **UEXKÜLL & STOLBERG**
**Patentanwälte**
**Beselerstrasse 4**
**D-22607 Hamburg (DE)**

(54) **Verfahren und Vorrichtung zur Messung der Dielektrizitätskonstante von Probenmaterialien.**

(57) Die Erfindung betrifft eine Vorrichtung und ein Verfahren zur Messung der komplexen Dielektrizitätskonstante eines Stoffes durch Auswertung der durch die Anwesenheit des Stoffes verursachten Verstimmung eines HF-Resonators. Zur Vereinfachung der Meß- und Auswerteschaltungen, und um eine kontinuierliche Messung eines Materialstroms zu ermöglichen, sind erfindungsgemäß zwei baugleiche HF-Resonatoren (8, 8') vorhanden, die jeweils einen dielektrischen Festkörperresonator (1, 1') in einem Gehäuse mit einem ersten leitfähigen Abschnitt (2, 2') und einem zweiten für Wechselfelder durchlässigen Abschnitt (3, 3') aufweisen. Die beiden HF-Resonatoren werden so zueinander positioniert, daß ihre leitfähigen Gehäuseabschnitte (2, 2') sie gegen wechselseitige Beeinflussung abschirmen und ihre für elektromagnetische Felder durchlässigen Abschnitte (3, 3') dem zu messenden Stoff (10) zugewandt sind. Die in die beiden HF-Resonatoren eingekoppelte Betriebsfrequenz und/oder die Resonanzfrequenzen der HF-Resonatoren (8, 8') werden so gewählt, daß in Abwesenheit des zu messenden Stoffes die gemeinsame Betriebsfrequenz genau in der Mitte zwischen den Resonanzfrequenzen der HF-Resonatoren (8, 8') liegt. Auf Grundlage der gemessenen Amplitudenwerte der jeweils in den beiden HF-Resonatoren empfangenen HF-Signale und deren Summen- und Differenzwerten kann die komplexe Dielektrizitätskonstante des Stoffes bestimmt werden. Dadurch kann auf ein Durchmessen der Resonanzkurven der HF-Resonatoren verzichtet werden.

FIG. 4

Rank Xerox (UK) Business Services
(3.10/3.09/3.3.4)

EP 0 657 733 A2

Die Erfindung betrifft ein Verfahren und eine Vorrichtung zur Messung der komplexen Dielektrizitätskonstante eines Stoffes durch Auswertung der durch die Anwesenheit des Stoffes verursachten Verstimmung eines HF-Resonators, wobei eine HF-Sendeeinrichtung zum Senden hochfrequenter elektromagnetischer Felder mit variierbarer Frequenz in den HF-Resonator, eine Empfangseinrichtung für das Resonatorfeld und eine mit der Empfangseinrichtung verbundene Meßschaltung vorhanden ist, mit der die Amplitude der empfangenen Hochfrequenzsignale bestimmbar ist

Es sind verschiedene Verfahren zur Bestimmung von dielektrischen Eigenschaften von Stoffen, die typischerweise als Dielektrizitätszahl $\epsilon_r$ und Verlustwinkel $\tan(\delta)$ oder als komplexe Dielektrizitätskonstante $\epsilon = \epsilon' - i\epsilon''$ angegeben werden, bekannt. Solche Verfahren finden zum Beispiel bei der Bestimmung der Feuchte von Stoffen Anwendung. Diese Verfahren beruhen auf der großen Dielektrizitätskonstante und dem großen Verlustfaktor des Wassers in dem Stoff und haben im industriellen Bereich große Bedeutung, beispielsweise bei der Feuchtemessung von Chemikalien, Nahrungsmitteln, Tabak, Kaffee, etc.. Bei den Resonanzverfahren zur Bestimmung der Feuchte mit Hilfe von Mikrowellen wird der zu untersuchende Stoff in einen Hohlraumresonator eingebracht und die durch die Anwesenheit des Stoffes bedingte Verstimmung des Hohlraumresonators gemessen, indem durch Variieren der eingestrahlten Frequenz die Resonanzkurve abgefahren und ausgemessen wird. Aus der Verschiebung der Resonanzfrequenz und der Vergrößerung der Resonanzhalbwertsbreite bzw. Güteänderung des Resonators läßt sich bei bekannter Stoffzusammensetzung und -dichte die Dielektrizitätskonstante und damit auch der Wassergehalt des Stoffes ableiten. Dazu bedarf es in der Regel Kalibrationskurven, die durch vorherige Messung der jeweiligen Substanz mit verschiedenen bekannten Feuchtegraden gewonnen werden. Bei den meisten bekannten Verfahren ist überdies eine gesonderte Messung der Materialdichte erforderlich.

Aus der DE-OS 40 04 119 ist ein Verfahren zur Bestimmung der Materialfeuchte mit Hilfe eines Hohlraumresonators bekannt, das durch eine bestimmte Auswahl des Feldverlaufs des Hohlraumresonators im Bereich der zu untersuchenden Probe gestattet, Materialfeuchte und Materialdichte unabhängig voneinander für ein bekanntes Material unter Verwendung einer Kalibrationskurve zu bestimmen, wobei die durch Abfahren der Resonanzkurve ermittelte Resonanzfrequenz und die Halbwertsbreite der Resonanzlinie bestimmt und ausgewertet werden. Auch hier ist es notwendig, daß der zu untersuchende Stoff in Form einer Probe in den Hohlraumresonator eingebracht wird.

Aus dem Artikel "Ein Dielektrizitätskonstanten-Meßplatz zur Untersuchung optischer Kristalle im Mikrowellenbereich" in: Kristall und Technik, Bd. 10 , Nr. 6, 1975, S. 695-700, von E. Wehrsdorfer et al., ist ein ähnliches Verfahren wie das obige bekannt, bei dem die Dielektrizitätskonstante einer Probe durch die Belastung eines im Mikrowellenbereich betriebenen Hohlraumresonators durch die Probe bestimmt wird. Die durch die Anwesenheit der Probe in dem Hohlraumresonator bedingte Resonanzfrequenz- und Güteänderung wird durch Ausmessen der Resonanzkurve nach Einbringen der Probe in den Hohlraumresonator bestimmt.

Für die meisten industriellen Anwendungen sind die bekannten Resonanzverfahren zur Bestimmung dielektrischer Eigenschaften eines Stoffes jedoch in der Hinsicht nachteilig, daß der zu untersuchende Stoff jeweils als Probe unter genau definierten Bedingungen in einen Hohlraumresonator eingebracht werden muß. Bei kontinuierlichen Herstellungs- und Verarbeitungsverfahren können daher jeweils nur von Zeit zu Zeit Stichproben entnommen und unter relativ großem Aufwand in dem Hohlraumresonator gemessen werden. Eine solche stichprobenartige Messung erlaubt einen Zugriff auf die gewünschten Meßgrößen nur mit Zeitverzögerung, ferner ist nicht sichergestellt, daß die Materialeigenschaften sich bei der Entnahme der Probe und anschließenden Messung nicht gegenüber denen in dem eigentlich zu messenden Materialstrom verändern. In einem kontinuierlichen Herstellungs- oder Verarbeitungsprozeß wäre es dagegen vielmehr erwünscht, kontinuierlich den Momentanwert bestimmter dielektrischer Meßgrößen oder daraus abgeleitete Größen wie etwa die Feuchte eines Stoffes zur Verfügung zu stellen. Dies ist aber bei Verfahren, die mit geschlossenen Hohlraumresonatoren arbeiten, grundsätzlich nicht möglich.

Aus der DD-PS 138 468 ist ein Verfahren zur Messung der komplexen Dielektrizitätskonstanten von dielektrischen Platten bekannt, die einseitig metallisiert sind. Zur Messung wird ein dielektrischer Resonator auf die nichtmetallisierte Seite der Platte aufgelegt und in dem Resonator die $E_{011}$-Mode angeregt. Die metallisierte Seite der Platte wirkt als Abschluß des resonanzfähigen Systems. Aus der Änderung der Resonanzfrequenz gegenüber dem Fall, bei dem der dielektrische Resonator auf eine Metallplatte aufgelegt ist, kann die Dielektrizitätskonstante des Plattenmaterials bei bekannter Dicke bestimmt werden. Nachteilig an diesem Verfahren ist, daß nur einseitig metallisierte Platten bekannter Dicke gemessen werden können; ferner muß die Resonanzkurve für jede Messung durchgefahren werden, um die Resonanzfrequenz zu bestimmen.

Versuche mit "offenen" Hohlraumresonatoren, z.B. Kammern mit schlitzartigen Öffnungen, die es ermöglichen könnten, das Resonatorfeld mit einem außerhalb des Hohlraums befindlichen Stoff wechselwirken zu lassen, haben zu keinen befriedigenden Ergebnissen geführt, da einerseits die Sensivität relativ gering ist und andererseits die Abstrahlung von Mikrowellenleistung relativ hoch ist.

Zudem weisen alle bekannten Sensorvorrichtungen den Nachteil auf, daß viele Meßpunkte bei verschiedenen in den Resonator eingestrahten Frequenzen gemessen werden müssen, um aus dieser Vielzahl von Meßpunkten die Resonanzkurve zu erhalten, deren Mittelwert und Halbwertsbreite anschließend bestimmt werden müssen. Diese Vorgehensweise bedingt einen nicht unerheblichen Schaltungsaufwand, da eine Vielzahl von Meßwerten bei verschiedenen Frequenzen aufgenommen, abgespeichert und anschließend ausgewertet werden müssen.

Es ist Aufgabe der Erfindung, ein Verfahren und eine Vorrichtung zur Bestimmung dielektrischer Eigenschaften eines Stoffes durch Auswertung der durch die Anwesenheit des Stoffes verursachten Verstimmung eines Hochfrequenzresonators zu schaffen, die es ermöglichen, die gewünschten dielektrischen Eigenschaften des Stoffes kontinuierlich und ohne Zeitverzögerung und mit geringem schaltungstechnischem Aufwand zu messen.

Zur Lösung dieser Aufgabe dient die Vorrichtung mit den kennzeichnenden Merkmalen des Patentanspruchs 1 in Verbindung mit dessen Oberbegriff und das Verfahren mit den kennzeichnenden Merkmalen des Patentanspruchs 12 in Verbindung mit dessen Oberbegriff. Vorteilhafte Ausführungsformen sind in den Unteransprüchen aufgeführt.

Erfindungsgemäß sind zur Messung der dielektrischen Eigenschaften des zu untersuchenden Stoffes zwei baugleiche HF-Resonatoren vorhanden, die jeweils durch einen dielektrischen Festkörperresonator gebildet werden. Es wurde gefunden, daß Festkörperresonatoren Eigenschaften haben, die sie zur Verwendung in Hochfrequenz-Meßvorrichtungen für dielektrische Stoffeigenschaften geeignet machen. Das elektromagnetische Feld ist nämlich nicht in dem dielektrischen Material des Resonators eingeschlossen, sondern es existiert auch außerhalb des Resonators ein nicht verschwindendes Feld. Dieses Feld außerhalb des Resonators fällt sehr schnell ab, so daß keine Probleme durch Abstrahlung elektromagnetischer Energie auftreten, andererseits aber durch das nicht verschwindende Feld außerhalb des Resonators genügend Sensitivität für die Anwesenheit eines Stoffes in der Nähe gegeben ist. Gemessen werden die in einer Empfängereinrichtung nahe an den Festkörperresonatoren durch die Resonatorfelder induzierten Signale, die über bekannte Meßschaltungen, beispielsweise mit Spitzenwertgleichrichtung gewandelt werden.

Die Festkörperresonatoren sind jeweils in einem Gehäuse untergebracht, das in einem ersten Abschnitt, welcher wenigstens eine Hemisphäre überdeckt, aus leitfähigem Material und in einem zweiten Abschnitt aus für elektromagnetische Felder durchlässigem Material besteht. Die beiden HF-Resonatoren werden so zueinander positioniert, daß ihre leitfähigen Gehäuseabschnitte die Festkörperresonatoren gegen eine gegenseitige Beeinflussung durch das Feld des jeweils anderen Resonators abschirmen und die für elektromagnetische Felder durchlässigen Abschnitte auf den zu messenden Stoff gerichtet sind; eine Abschirmung der Festkörperresonatoren gegeneinander durch leitfähige Gehäuseabschnitte ist erforderlich, da beide HF-Resonatoren relative nahe beieinander liegen müssen, um auf denselben oder eng benachbarte Bereiche des zu messenden Stoffes gerichtet zu sein.

In die beiden HF-Resonatoren werden die gleichen Hochfrequenzfelder eingekoppelt, d.h. beide Resonatoren werden mit der gleichen Frequenz betrieben, wobei diese Frequenz so ausgewählt ist, daß sie bei Abwesenheit des zu messenden Stoffes genau in der Mitte zwischen der voreingestellten Resonanzfrequenz des ersten Resonators und der davon verschieden voreingestellten Resonanzfrequenz des zweiten Resonators liegt. Die durch die Anwesenheit des zu messenden Stoffes verursachte Verstimmung der HF-Resonatoren wirkt sich dahingehend aus, daß sich aufgrund der Verschiebung der Resonanzkurve bei konstanter eingekoppelter Frequenz jeweils der Arbeitspunkt des HF-Resonators auf der Resonanzkurve verschiebt und sich die Resonanzkurven verbreitern (Güteänderung), wobei beides eine Änderung der gemessenen Amplituden der Resonatorfelder zur Folge hat. Jedoch lassen sich aus der Summe und der Differenz der an den beiden Resonatoren gemessenen Resonatorfelder bei Anwesenheit des Stoffes dessen dielektrische Eigenschaften vollständig bestimmen; diese Auswertung erfolgt in einer Steuer- und Auswerteeinheit, die die gemessenen Amplitudenwerte der Resonatorfelder aufnimmt, Summen- und Differenzwerte bildet und entweder analytische Formeln für deren Zusammenhang mit der komplexen Dielektrizitätskonstante oder empirisch ermittelte Eichkurven verwendet.

Es ist bemerkenswert, daß bei der erfindungsgemäßen Vorgehensweise auf ein Durchfahren oder Abtasten der Resonanzkurven vollständig verzichtet werden kann und beide Resonatoren während des ganzen Meßvorgangs mit der gleichen, konstanten Frequenz betrieben werden können. Dadurch ergibt sich eine erhebliche Vereinfachung der Vorrichtung. Auch ist eine überaus einfache Justierung der Frequenzen der erfindungsgemäßen Vorrichtung möglich, indem bei Abwesenheit des zu messenden Stoffes die Betriebsfrequenz oder die Resonanzfrequenzen der HF-Resonatoren so eingestellt werden, daß beide HF-Resonatoren Ausgangssignale gleicher Höhe liefern, wodurch sichergestellt ist, daß die Betriebsfrequenz genau in der Mitte zwischen den Resonanzfrequenzen der HF-Resonatoren liegt, da die Resonatorenen gleiche, aber gegeneinander verschobene Resonanzkurven haben.

Gemäß der Erfindung lassen sich Materialuntersuchungen kontinuierlich und ohne gesonderte Probenentnahme vornehmen, indem die beiden HF-Resonatoren so nebeneinanderliegend angeordnet werden, daß ihre leitfähigen Gehäuseabschnitte sie gegeneinander abschirmen und sie mit ihren für elektromagnetische Felder durchlässigen Abschnitten auf einen Materialstrom gerichtet sind, der dadurch kontinuierlich und ohne Zeitverzögerung auf seine dielektrischen Eigenschaften untersucht wird.

Ein weiterer Vorteil der Erfindung besteht in dem, verglichen mit Hohlraumresonatoren, kompakten und robusten Aufbau mit dielektrischen Resonatoren.

Die Erfindung hat besondere Bedeutung für die Bestimmung des Feuchtegehalts von Stoffen, der sich aus den dielektrischen Eigenschaften ableiten läßt. Daneben ist das Verfahren aber auch für alle anderen Meß- und Überwachungsverfahren geeignet, die die dielektrischen Eigenschaften eines Stoffes zu Auswertezwecken heranziehen, beispielsweise die Bestimmung von Schichtdicken eines bekannten Materials.

Die Erfindung wird im folgenden anhand von Ausführungsbeispielen in den Zeichnungen erläutert, in denen:

| Figur 1 | einen einzelnen HF-Resonator im seitlichen Schnitt zeigt, der als dielektrischer Resonator in einem Gehäuse ausgebildet ist; |
| --- | --- |
| Figur 2 | einen Schnitt durch den HF-Resonator aus Figur 1 entlang der Linie II-II zeigt; |
| Figuren 3A-C | Ersatzschaltbilder für den Resonatorstromkreis zeigen; |
| Figur 4 | eine schematische Darstellung von zwei symmetrisch über dem Meßgut angeordneten dielektrischen Resonatoren zeigt; |
| Figur 5 | die Resonanzkurven des ersten (gestrichelt) und des zweiten Resonators (durchgezogen) ohne das zu messende Material (fette Linien) und mit dem zu messenden Material (dünne Linien) zeigt, wobei $\Delta\epsilon'' = 0$ ist; und |
| Figur 6 | die Resonanzkurven des ersten (gestrichelt) und des zweiten Resonators (durchgezogen) ohne das zu messende Material (fette Linien) und mit dem zu messenden Material (dünne Linien) zeigt, wobei $\Delta\epsilon' = 0$. |

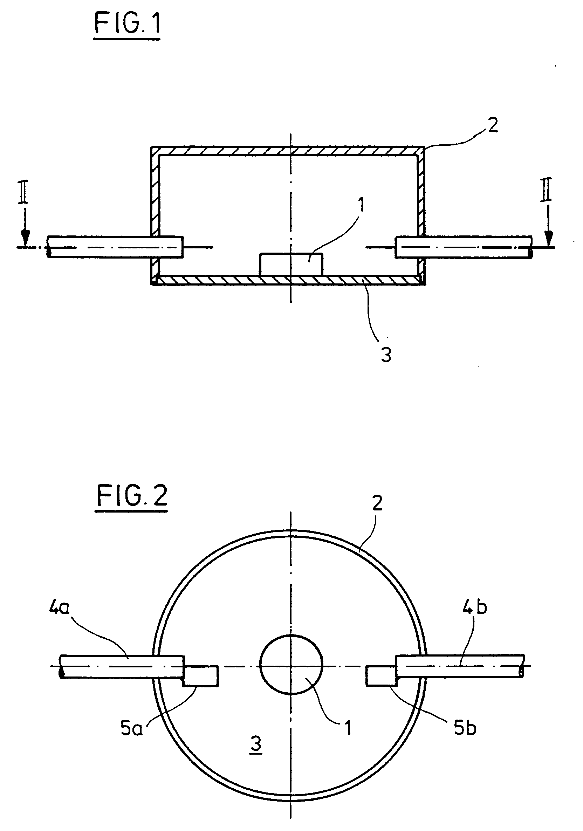

In Figur 1 ist ein einzelner HF-Resonator für die erfindungsgemäße Vorrichtung gezeigt. Der HF-Resonator weist ein zylindrisches Gehäuse mit einem ersten Abschnitt 2 aus Kupfer und mit einem zweiten, eine der Grundflächen des Zylinders bildenden Abschnitt 3 auf, der für elektromagnetische Wellen durchlässig ist und z.B. aus Keramik oder Kunststoff besteht. In dem Gehäuse 2, 3 befindet sich ein scheibenförmiger dielektrischer Resonator 1, der in dem gezeigten Ausführungsbeispiel auf der Grundfläche 3 aufliegt, aber auch mit Abstandshaltern in dem Gehäuse gehalten sein kann. Zur Einkopplung eines elektromagnetischen HF-Feldes in den dielektrischen Resonator 1 bzw. zum Empfang des Resonatorfeldes sind Koaxialkabel 4a bzw. 4b vorgesehen, die an gegenüberliegenden Punkten in das Gehäuse eingeführt sind und an ihren dem dielektrischen Resonator 1 zugewandten Enden Koppelschleifen 5a und 5b aufweisen, die durch eine einfache Leiterschleife zwischen dem Mittelleiter und der Abschirmung des Koaxialkabels 4a bzw. 4b gebildet sind.

Für die Auslegung eines rotationssymmetrischen Festkörperresonators, insbesondere eines scheibenförmigen Resonators mit dem Radius a und der Höhe h, kann folgende Betrachtung dienen. Für die z-Komponente des magnetischen Feldes kann innerhalb des Resonators die Form

$$H_z \propto J_0(k_d r)$$

und außerhalb

$$H_z \propto K_0(hr)$$

angenommen werden, wobei $k_d$ und ih die Grenzwellenzahlen innerhalb und außerhalb des Resonators und $J_0$ und $K_0$ die Besselfunktionen 0-ter Ordnung für reelle und imaginäre Argumente sind. Die Grenzwellenzahlen sind mit der Resonatorwellenzahl $\beta$ und der Vakuumwellenzahl k durch die Beziehung verknüpft:

$$\beta_c^2 = k^2 - \beta^2$$

In r- und z-Richtung müssen folgende Randbedingungen näherungsweise erfüllt sein:

$$\beta_d^2 = \left(\frac{p_{01}}{a}\right)^2 \, , \qquad \beta^2 = \left(\frac{\pi}{L}\right)^2$$

wobei $p_{01}$ die erste Wurzel von $J_0$ ist. Weiterhin gilt:

$$k^2 = \frac{\omega^2}{c^2} = \omega^2 \mu_r \mu_0 \varepsilon_r \varepsilon_0 = \kappa k_0^2 \, ,$$

$$x = \epsilon_r \mu_r$$

Setzt man nun L = a, eine Frequenz von 2.5 GHz, einen typischen Wert $\epsilon_r$ von 38 für den Resonator und $p_{01}$ = 2.405 an, so ergibt sich aus

$$k^2 = \frac{\pi^2}{a^2} + \frac{p_{01}^2}{a^2} = \frac{(2\pi f)^2}{c^2} \varepsilon_r$$

eine Resonatordimensionierung von a = L = 12.25 mm.

In den HF-Resonatoren sind ferner Einrichtungen zum Verstellen der Resonanzfrequenz (nicht gezeigt) vorgesehen; solche Einrichtungen können z.B. aus Abstimmkörpern bestehen, deren Lage relativ zu dem dielektrischen Resonator 1 verstellbar ist. Im einfachsten Fall kann dies eine Metallschraube sein, die auf eine gewünschte Tiefe in das Resonatorgehäuse 2, 3 eingedreht und damit in einen gewünschten Abstand zu dem dielektrischen Resonator gebracht wird. Allgemein können jedoch auch dielektrische oder magnetische Abstimmkörper verwendet werden, deren Lage manuell oder durch einen Antriebsmechanismus und gesteuert durch externe Signale aus der Steuer- und Auswerteeinheit eingestellt wird. Es können auch fest angebrachte Abstimmkörper vorgesehen werden, deren dielektrische, magnetische oder metallische Eigenschaften sich durch Anlegen von elektrischen Steuersignalen variieren lassen, wodurch ebenfalls eine Verstellung der Resonanzfrequenz des HF-Resonators erreicht wird.

Zur Einkopplung eines elektromagnetischen HF-Feldes in den dielektrischen Resonator 1 bzw. zum Empfang des Resonatorfeldes vorgesehenen Koppelschleifen 5a und 5b sind symmetrisch ausgebildet, wonach die Auswahl als Sende- und Empfängerschleife willkürlich ist. Betrachtet man die Koppelschleife 5b als Empfänger, so werden die darin durch das Resonatorfeld des Festkörperresonators 1 induzierten Signale über das Koaxiakabel 4b abgeleitet und einer Meßschaltung zugeführt, die z.B. über eine Spitzenwertgleichrichtung ein der Amplitude des Resonatorfeldes entsprechendes Signal erzeugt. Dieses Signal wird anschließend nach Analog/Digital-Wandlung in der Steuer- und Auswerteeinheit weiterverarbeitet, wobei es sich typischerweise um einen Mikroprozessor handeln wird.

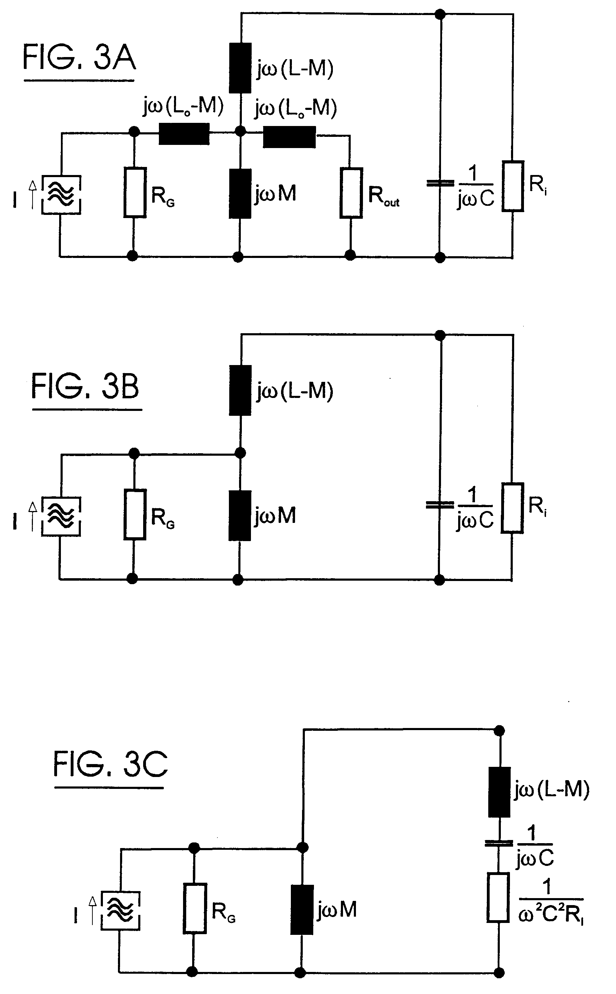

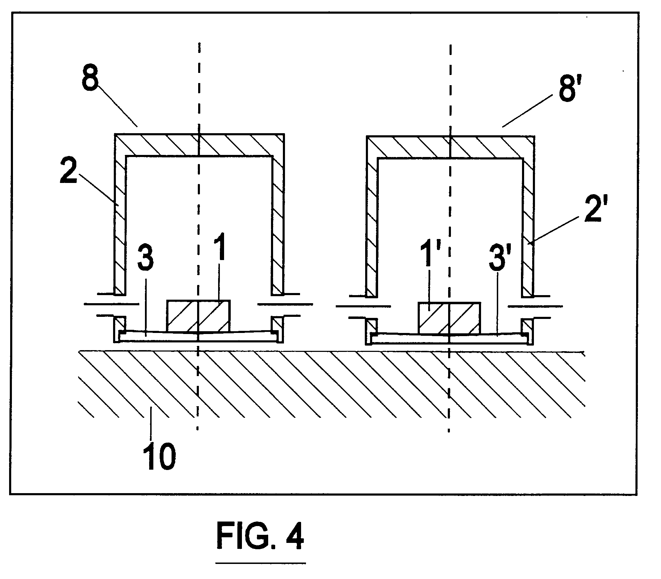

Die folgende Beschreibung soll zur Erläuterung der Zusammenhänge dienen, aus denen sich ergibt, daß sich aus der Summe und der Differenz der Signale einer symmetrischen Gruppe von zwei HF-Resonatoren die dielektrischen Eigenschaften eines wie in Figur 4 gezeigt vor die Resonatorgruppe gebrachten Stoffes eindeutig bestimmen lassen. Zu diesem Zweck wird das Ersatzschaltbild eines einzelnen HF-Resonators betrachtet. In Figur 3A ist ein Ersatzschaltbild des HF-Resonators als RLC-Schwingkreis dargestellt. Die Ankopplung der HF-Felder über Leiterschleifen kann im Ersatzschaltbild durch eine äquivalente Transformatorschaltung berücksichtigt werden. Da die Leiterschleifen zur Ein- und Auskopplung des Feldes in den Resonator an diametral gegenüberliegenden Positionen bezüglich des Festkörperresonators erfolgt, können sie als parallele Transformatoren betrachtet werden. Kombiniert man diese zu einer Gegeninduktivität M, so ergibt sich das in Figur 3A gezeigte Ersatzschaltbild. Im übrigen werden für die an den Schaltsymbolen angezeigten Impedanzen folgende Größen benutzt:

| | |
|---|---|
| $R_G$ | Innenwiderstand des HF-Generators (Konstantstromquelle) |
| $L_0$ | Induktivität der Koppelschleife |
| L | Induktivität des Resonators |
| M | Gegenseitige Kopplungsinduktivität |
| C | Kapazität des Resonators |

$R_i$      Innenwiderstand des Resonators
$R_{out}$      Ausgangswiderstand

Da die Koppelschleife 5a vollständig im Streufeld des dielektrischen Resonators 1 liegt und die Anzahl ihrer Windungen 1 ist, kann man annehmen, daß

$$M \approx L_O$$

Weiterhin kann man annehmen:

$$R_{out} >> \omega M$$
$$R_G >> \omega M$$

Unter diesen Annahmen vereinfacht sich das Ersatzschaltbild zu dem in Figur 3B gezeigten.

Als nächstes wird die parallele Impedanz auf der rechten Seite von Figur 3B unter der Annahme:

$$\omega \cdot C \cdot R_i = Q_i >> 1$$

in folgende äquivalente Reihenimpedanz transformiert

$$Z_s \approx \frac{1}{\omega^2 C^2 R_i} - j\frac{1}{\omega C}$$

Damit ergibt sich das in Figur 3C gezeigte Ersatzschaltbild. Die Eingangsimpedanz dieses Kreises ist:

$$Z_{in} = j\omega M + \frac{\omega^2 M \left[ \dfrac{1}{\omega^2 C^2 R_i} - j\left(\omega L - \dfrac{1}{\omega C}\right) \right]}{\left(\dfrac{1}{\omega^2 C^2 R_i}\right)^2 + \left(\omega L - \dfrac{1}{\omega C}\right)^2}$$

In der Nähe der Resonanzfrequenz kann der erste Summand dieses Ausdrucks gegen den zweiten vernachlässigt werden, so daß sich folgender Absolutwert für die Eingangsimpedanz ergibt:

$$|Z_{in}| = \frac{\omega^4 M^2 C^2 R_i}{\sqrt{1 + \left(\omega L - \dfrac{1}{\omega C}\right)^2 (\omega^2 C^2 R_i)^2}}$$

wobei ausgenutzt worden ist, daß

$$\omega^2 C^2 R_i = \frac{\dfrac{\omega C}{G_i}}{\dfrac{1}{\omega C}} = \frac{Q_i}{\dfrac{1}{\omega C}} > 1$$

ist. Dies ist einerseits durch den hohen $Q_i$-Wert des unbelasteten dielektrischen Resonators bedingt; andererseits ist in der Nähe der Resonanzfrequenz $1/\omega C$ nahe an dem Wert von $\omega L$. Die letztere Größe läßt sich leicht bestimmen, da die Induktivität eines scheibenförmigen dielektrischen Resonators mit dem Radius a und der Höhe h durch

$$L = \mu_0 a \left( \ln\frac{a}{h} + \frac{3}{2} \right)$$

gegeben ist, was bei typischen Werten, a = 6 mm, h = 4 mm und einer Frequenz von 2.5 GHz folgenden Wert ergibt:

$\omega L \approx 225 \, \Omega$

Entwickelt man den obigen Ausdruck für die Eingangsimpedanz $|Z_{in}|$ in eine Taylor-Reihe um die Resonanzfrequenz $\omega_0$, erhält man

$$\left| Z_{in} \right| = \omega^4 M^2 C^2 R_i \left[ 1 - 2Q_i^2 \left( \frac{\Delta\omega}{\omega_0} \right)^2 \right]$$

wobei

$Q_i = \omega_0 C R_i$

benutzt wurde.

Weiterhin wird ein Kopplungskoeffizient k eingeführt, der definiert ist als

$$k = \frac{M}{L} \approx \frac{L_0}{L}$$

wobei die obige Näherung $M \approx L_0$ benutzt worden ist. Die Induktivität der Kopplungsschleife $L_0$, deren Schleifenradius als b und deren Leiterradius als r bezeichnet wird, ist gegeben durch

$$L_0 = \mu_0 b \left( \ln\frac{b}{r} + \frac{1}{4} \right)$$

Bei einer Frequenz von 2.5 GHz, b = 1.5 mm, r = 0.5 mm ist $wL_0$ = 39 $\Omega$. Der Kopplungskoeffizient beträgt dann etwa $k \cong 0.177$.

Setzt man die Definition von k in die Formel für $|Z_{in}|$ ein, erhält man

$$\left| Z_{in} \right| = k^2 \frac{\omega_0^4}{\omega^4} R_i \left[ 1 - 2Q_i^2 \left( \frac{\Delta\omega}{\omega_0} \right)^2 \right]$$

Schließlich wird der Ausgangswiderstand $R_{out}$ im Nachhinein berücksichtigt. Da $R_i$ einen sehr hohen Wert hat, der gegeben ist als

$$R_i = Q_i \frac{1}{\omega_0 C} \cong 2000 \cdot 225 \Omega = 450 k\Omega$$

wird der Gesamtfaktor vor der Klammer in der obigen Gleichung für $|Z_{in}|$ gleich dem Ausgangswiderstand, wenn dieser klein genug ist. Damit erhält man schließlich:

$$\left|Z_{in}\right| = R_{out}\left[1-2Q_i^2\left(\frac{\Delta\omega}{\omega_0}\right)^2\right]$$

Mit Hilfe dieser Beziehung kann man nun den Einfluß eines zu messenden Materials in der Nähe des Festkörperresonators ableiten. Der Einfluß von kleinen Änderungen in $\epsilon'$ auf $|Z_{in}|$ in der Nähe der Resonanzfrequenz $\omega_0$, d.h. $\Delta\omega = \omega - \omega_0 << \omega_0$, wie er durch die Anwesenheit des zu untersuchenden Stoffes in der Nähe des Resonators verursucht wird, läßt sich beschreiben durch:

$$\frac{d|Z_{in}|}{d\epsilon'} = \frac{d|Z_{in}|}{d\omega_0}\frac{d\omega_0}{d\epsilon'} = -2R_{out}Q_i^2\frac{d}{d\omega_0}\left(\frac{\omega-\omega_0}{\omega_0}\right)^2\frac{d\omega_0}{d\epsilon'}$$

$$= 4R_{out}Q_i^2\frac{\omega(\omega-\omega_0)}{\omega_0^3}\frac{d\omega_0}{d\epsilon'}$$

Mit den Beziehungen

$$\omega_0 = \frac{1}{\sqrt{LC}} = \frac{1}{\sqrt{LC_0\epsilon'}}$$

$$\frac{d\omega_0}{d\epsilon'} = -\frac{1}{2}\omega_0\frac{1}{\epsilon'}$$

erhält man schließlich:

$$\Delta|Z_{in}| = -2R_{out}Q_i^2\frac{\omega-\omega_0}{\omega_0}\frac{1}{\epsilon'}\Delta\epsilon' \propto \Delta\epsilon'$$

Dabei ist zu beachten, daß das Vorzeichen der Änderung von $|Z_{in}|$ mit ansteigendem $\epsilon'$ davon abhängt, ob die Resonanzfrequenz $\omega_0$ oberhalb oder unterhalb der Betriebsfrequenz $\omega$ liegt. D.h. im Fall von zwei symmetrisch oberhalb und unterhalb der Betriebsfrequenz betriebenen Resonatoren ist die Differenz der Signale von den beiden Resonatoren F1 - F2 proportional zu $\Delta\epsilon'$.

Nun wird der Einfluß von Änderungen im Imaginärteil der Dielektrizitätskonstantenbetrachtet. Der Imaginäranteil $\epsilon''$ ist in der oben schon angegebenen Gleichung

$$\left|Z_{in}\right| = R_{out}\left[1-2Q_i^2\left(\frac{\Delta\omega}{\omega_0}\right)^2\right]$$

in $Q_i$ verborgen, das als

$$Q_i = \frac{1}{\tan(\delta)} = \frac{\epsilon'}{\epsilon''}$$

angegeben werden kann, womit sich

$$|Z_{in}| = R_{out}[1-2\frac{\varepsilon'^2}{\varepsilon''^2}(\frac{\Delta\omega}{\omega_0})^2]$$

ergibt. Daraus erhält man schließlich die Änderung von $|Z_{in}|$ mit $\epsilon''$:

$$\Delta|Z_{in}| = \frac{d|Z_{in}|}{d\varepsilon''}\Delta\varepsilon'' = -4R_{out}\frac{\varepsilon'^2}{\varepsilon''^3}(\frac{\Delta\omega}{\omega_0})^2\Delta\varepsilon'' \propto \Delta\varepsilon''$$

Hier ist nun zu beachten, daß im Gegensatz zu der obigen Abhängigkeit von $\Delta|Z_{in}|$ von $\epsilon'$, das Vorzeichen von $\Delta|Z_{in}|$ bei Änderung von $\epsilon''$ nicht davon abhängt, ob der Resonator oberhalb oder unterhalb seiner Resonanzfrequenz $\omega_0$ betrieben wird. Daraus ergibt sich die Schlußfolgerung, daß im Fall von zwei symmetrisch oberhalb und unterhalb der Resonanzfrequenz betriebenen Resonatoren die Summe der Signale des ersten und des zweiten Resonators proportional zu $\Delta\epsilon''$ ist; in der Summe heben sich, wie oben gesehen, aufgrund gegenläufiger Vorzeichen die Effekte von Änderungen in $\epsilon'$ auf, so daß die Summe ausschließlich auf Änderungen in $\epsilon''$ sensitiv ist.

Auf die Differenz, die wie gesehen proportional zu $\Delta\epsilon'$ ist, wirken sich hingegen Änderungen von $\epsilon''$ nicht aus, da sie mit mit gleichen Vorzeichen für den ersten und den zweiten Resonator auftreten und sich somit in der Differenz wegheben.

Zusammenfassend ergibt sich daraus, daß bei einem symmetrischen Resonatorpaar Summe und Differenz der gemessenen Signale F1 und F2 "orthogonal" zueiander sind und die durch $\epsilon'$ und $\epsilon''$ bedingten Effekte entkoppeln. Sinnvolle Normierungen der Summen und Differenzen sind:

$$\Delta\varepsilon' \propto \frac{F1-F2}{F1_0+F2_0}$$

$$\Delta\varepsilon'' \propto \frac{F1_0+F2_0-(F1+F2)}{F1_0+F2_0}$$

wobei $F1_0$ und $F2_0$ die im Leerlauf, d.h. in Abwesenheit des zu messenden Stoffes erhalten Signale des ersten und des zweiten Resonators sind.

Figur 4 zeigt nebeneinanderliegend zwei HF-Resonatoren, die mit ihren für elektromagnetische Felder durchlässigen Gehäuseabschnitten 3 dem zu messenden Stoff 10 zugewandt sind, während ihre leitfähigen Gehäuseabschnitte sie gegen wechselseitige Beeinflussung ihrer Resonatorfelder abschirmen. Durch die metallischen Gehäuseabschnitte 2 wird die oberhalb der Resonatoren 1 liegende Hemisphäre abgeschirmt; ferner wird eine gewisse Richtwirkung erzielt, durch die das aus dem dielektrischen Resonator 1 austretende Resonatorfeld auf den darunter befindlichen zu messenden Stoff gerichtet wird.

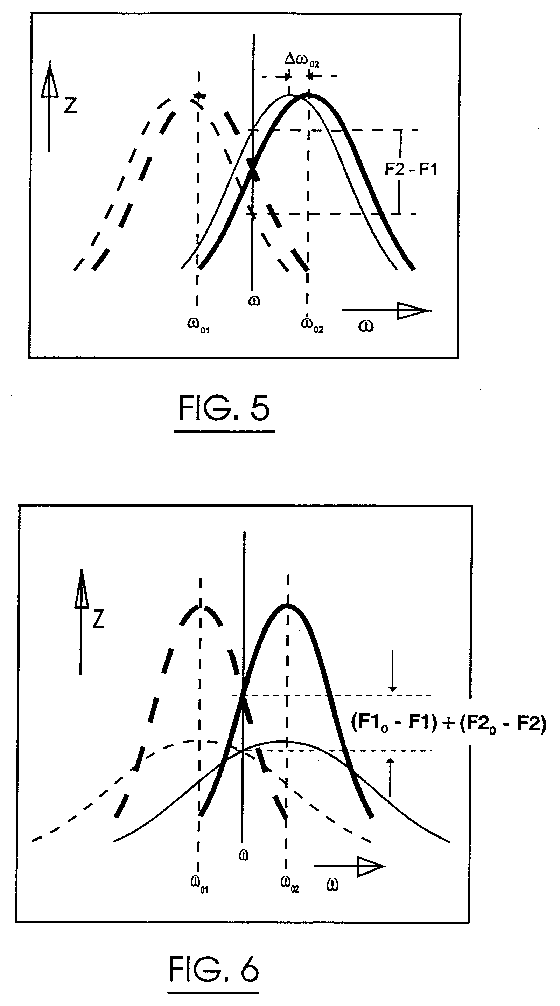

In die HF-Resonatoren 8, 8' wird das gleiche HF-Feld mit der Frequenz $\omega$ über die Koppelschleifen (4a in Fig. 1) eingespeist. Die beiden HF-Resonatoren 8, 8' sind so ausgelegt bzw. voreingestellt, daß sie im Leerlaufbetrieb (in Abwesenheit des zu messenden Stoffes) unterschiedliche Resonanzfrequenzen $\omega_{01}$ bzw. $\omega_{02}$ haben. Für eine solche Voreinstellung dienen die oben beschriebenen Einrichtungen zum Verstellen der Resonanzfrequenz. Die einheitliche Frequenz $\omega$, mit der beide Resonatoren betrieben werden, ist so eingestellt, daß die Betriebsfrequenz $\omega$ in der Mitte zwischen den Resonanzfrequenzen $\omega_{01}$ und $\omega_{02}$ liegt. Diese Verhältnisse sind in Figur 5 gezeigt, wobei die fett gezeichnete gestrichelte bzw. durchgezogene Kurve die Resonanzkurve des 1. bzw. 2. HF-Resonators bei Abwesenheit des Materials vor den HF-Resonatoren zeigt. Die Betriebsfrequenz $\omega$ liegt genau in der Mitte zwischen den Resonanzfrequenzen $\omega_{01}$ und $\omega_{02}$.

Wird das zu messende Material wie in Figur 4 dargestellt vor die HF-Resonatoren gebracht stellen sich die in den dünn gezeichneten Linien gezeigten Verhältnisse ein. Dabei ist zur Vereinfachung der Darstellung zunächst angenommen, daß lediglich eine Änderung im Realanteil der komplexen Dielektrizitätskonstanten auftritt, d.h. $\Delta\epsilon'' = 0$. Die Wirkung des vor die Resonatorgruppe auf Figur 4 gebrachten Materials besteht in diesem Fall darin, daß beide Resonanzkurven sich aus der symmetrischen Lage um die Betriebsfrequenz $\omega$ verschieben. Dies hat zur Folge, daß die beiden Resonatoren bei Einspeisung der Betriebsfrequenz $\omega$ nicht mehr bei symmetrischen Arbeitspunkten, d.h. in gleicher Entfernung von ihrer jeweiligen Resonanzfrequenz betrieben werden, sondern der Arbeitspunkt auf der einen Resonanzkurve aufwärts zur Resonanzfrequenz ($\omega_{02}$) hin und auf der anderen Resonanzkurve abwärts vom Resonanzmaximum (bei $\omega_{01}$) weg läuft. Dieses Verhalten korrespondiert mit dem oben gefundenen Ergebnis, daß $\Delta |Z_{in}|$ sich für ober- und unterhalb der Betriebsfrequenz liegende Resonanzfrequenzen in entgegengesetzte Richtung ändert. Die ursprünglich symmetrisch um die Betriebsfrequenz arbeitenden HF-Resonatoren liefern nun unterschiedliche Ausgabesignale F1 und F2 (gemessen wird z.B. die Amplitude des mit der Empfängerschleife 5b aufgenommenen Resonatorfeldes). Diese durch die Anwesenheit eines Materials vor der Resonatorgruppe bedingte Signaldifferenz der beiden HF-Resonatoren ist in Figur 5 als F2 - F1 bezeichnet.

In Figur 6 wird nun der Fall betrachtet, in dem die Anwesenheit eines Materials ausschließlich eine Änderung im Imaginäranteil der komplexen Dielektrizitätskonstante bewirkt, d.h. $\Delta\epsilon' = 0$ . In diesem Fall tritt keine Verschiebung, sondern eine Verbreiterung der Resonanzkurven, welche bei Anwesenheit des Materials mit dünn gezeichneten Linien dargestellt sind, auf. Daher ergibt sich auch keine Signaldifferenz zwischen den beiden HF-Resonatoren, da beide weiterhin symmetrisch um die Betriebsfrequenz $\omega$ arbeiten. Dies entspricht dem oben gefundenen Ergebnis, daß $|Z_{in}|$ sich mit $\epsilon''$ für ober- und unterhalb der Betriebsfrequenz liegende Resonanzfrequenzen in gleicher Richtung ändert. Es ergibt sich jedoch eine Differenz der Summe der Ausgabesignale $F1_0 + F2_0$ bei Abwesenheit eines zu messenden Stoffes und der Summe der Signale F1 + F2 bei Anwesenheit des zu messenden Stoffes. Die Differenz dieser beiden Summen $F1_0 + F2_0 - (F1 + F2)$ ist proportional zu der durch die Anwesenheit des untersuchten Materials bedingten Änderung in $\epsilon''$.

Die oben angegebenen Beziehungen

$$\Delta\epsilon' \propto \frac{F1-F2}{F1_0+F2_0}$$

$$\Delta\epsilon'' \propto \frac{F1_0+F2_0-(F1+F2)}{F1_0+F2_0}$$

gelten in guter Näherung nur in der Nähe der Resonanzfrequenz. Sie deuten jedoch das qualitative Verhalten der Signale auch in größerer Entfernung von der Resonanzfrequenz an. In Fällen, in denen die obigen analytischen Beziehungen für $\Delta\epsilon'$ und $\Delta\epsilon''$ keine ausreichende Beschreibung liefern, können sie durch verfeinerte, empirisch ermittelte Eichkurven ersetzt werden, die in der Steuer- und Auswerteeinheit gespeichert bereitgehalten werden können.

Eine besonders nützliche Fortbildung der Erfindung weist neben dem aus zwei HF-Resonatoren bestehenden Sensorpaar, wie es in Figur 4 gezeigt ist, ein weiteres Sensorpaar auf, das ebenfalls mit dergleichen Betriebsfrequenz $\omega$ versorgt wird und Resonanzfrequenzen symmetrisch darum hat; während das erste Sensorpaar wie in Figur 4 gezeigt auf das zu messende Material gerichtet ist, wird das zweite Sensorpaar auf ein Bezugsmedium gerichtet. Das Signal des zweiten Sensorpaars wird dergleichen Auswertung unterzogen wie das des ersten. Durch Vergleich des ersten, auf das zu messende Material gerichteten Sensorpaars mit dem zweiten, auf das Bezugsmedium gerichteten Sensorpaar ergeben sich sehr nützliche Bezugswerte. Als Bezugsmedium kann z.B. dienen:

- Leerer Raum (Luft),
- ein Bezugsmaterial mit bekannten Eigenschaften,
- eine trockene Probe desgleichen Materials wie das zu messende, wenn die Feuchte des letzteren zu bestimmen ist,
- eine dielektrische Schicht bekannter Dicke, wenn die Schichtdicke einer Schicht aus demgleichen Material gemessen werden soll,
- einen bekannten Abstand zu einem dielektrischen Körper, wenn ein unbekannter Abstand gemessen werden soll.

**Patentansprüche**

1. Vorrichtung zur Messung der komplexen Dielektrizitätskonstante eines Stoffes durch Auswertung der durch die Anwesenheit des Stoffes verursachten Verstimmung eines HF-Resonators, welche Vorrichtung eine HF-Sendeeinrichtung zum Senden hochfrequenter elektromagnetischer Felder mit variierbarer Frequenz in den HF-Resonator, eine Empfangseinrichtung für das Resonatorfeld und eine mit der Empfangseinrichtung verbundene Meßschaltung aufweist, mit der die Amplitude der empfangenen Hochfrequenzsignale bestimmbar ist, **dadurch gekennzeichnet**,
   - daß zwei baugleiche HF-Resonatoren (8, 8') vorhanden sind, die jeweils einen dielektrischen Festkörperresonator (1, 1') in einem Gehäuse mit einem ersten Abschnitt (2, 2'), welcher den Festkörperresonator wenigstens in einer Hemisphäre mit leitfähigem Material umschließt, und mit einem zweiten Abschnitt (3, 3'), der für elektromagnetische Wechselfelder durchlässig ist, und eine Einrichtung zum Verstellen der Resonanzfrequenz des HF-Resonators aufweisen,
   - daß die beiden HF-Resonatoren so zueinander positionierbar sind, daß ihre leitfähigen Gehäuseabschnitte (2, 2') sie gegen wechselseitige Beeinflussung abschirmen und ihre für elektromagnetische Felder durchlässigen Abschnitte (3, 3') dem zu messenden Stoff (10) zugewandt sind, und
   - daß eine Steuer- und Auswerteeinheit vorhanden ist, mit der die HF-Sendeeinrichtung und/oder die HF-Resonatoren so steuerbar sind, daß die beiden HF-Resonatoren mit HF-Feldern mit dergleichen Frequenz ($\omega$) gespeist werden, welche in Abwesenheit des zu messenden Stoffes in der Mitte zwischen den unterschiedlich voreingestellten Resonanzfrequenzen ($\omega_{01}$, $\omega_{02}$) des ersten und des zweiten HF-Resonators (8, 8') liegt, und die die gemessenen Amplitudenwerte der jeweils in den beiden HF-Resonatoren empfangenen HF-Signale aufnimmt und auf Grundlage von deren Summen- und Differenzwerten die komplexe Dielektrizitätskonstante des Stoffes bestimmt.

2. Vorrichtung nach Anspruch 1, **dadurch gekennzeichnet**, daß der zweite Abschnitt (3) des Gehäuses aus einem dielektrischen Material besteht.

3. Vorrichtung nach Anspruch 2, **dadurch gekennzeichnet**, daß der aus einem Dielektrikum bestehende zweite Abschnitt (3) des Gehäuses aus Kunststoff oder Keramik besteht.

4. Vorrichtung nach Anspruch 2 oder 3, **dadurch gekennzeichnet**, daß der erste Gehäuseabschnitt (2, 2') jedes HF-Resonators (8, 8') aus einem Metallzylinder besteht, dessen eine Grundfläche ganz oder teilweise offen ist, und der Zweite Abschnitt (3, 3') durch eine in der Öffnung der Grundfläche liegende dielektrische Wandfläche gebildet wird.

5. Vorrichtung nach einem der Ansprüche 2 bis 4, **dadurch gekennzeichnet**, daß der dielektrische Festkörperresonator (1, 1') direkt auf dem zweiten Gehäuseabschnitt (3, 3') aufliegend angebracht ist.

6. Vorrichtung nach Anspruch 4 oder 5, **dadurch gekennzeichnet**, daß der Durchmesser des zylindrischen Gehäuses kleiner als die halbe Grenzwellenlänge des Gehäuses ist.

7. Vorrichtung nach einem der vorhergehenden Ansprüche, **dadurch gekennzeichnet**, daß die Einrichtung zum Verstimmen des HF-Resonators einen in dem Gehäuse beweglich angeordneten dielektrischen, magnetischen oder metallischen Abstimmkörper aufweist, dessen Lage bezüglich des Festkörperresonators manuell oder gesteuert durch die Steuer- und Auswerteeinheit variierbar ist.

8. Vorrichtung nach einem der Ansprüche 1 bis 6, **dadurch gekennzeichnet**, daß die Einrichtung zum Verstimmen des HF-Resonators einen in dem Gehäuse angebrachten dielektrischen, magnetischen oder metallischen Körper aufweist, dessen dielektrische, magnetische oder metallische Eigenschaften durch von der Steuer- und Auswerteeinheit zugeführte Steuersignale variierbar sind.

9. Vorrichtung nach einem der vorhergehenden Ansprüche, **dadurch gekennzeichnet**, daß die beiden HF-Resonatoren (8, 8') auf gleicher Höhe so nebeneinenderliegend angeordnet sind, daß ihre zweiten, für elektromagnetische Wechselfelder durchlässigen Gehäuseabschnitte (3, 3') dem zu messenden Stoff (10) zugewandt sind.

10. Vorrichtung nach einem der vorhergehenden Ansprüche, **dadurch gekennzeichnet**, daß jeder dielektrische Resonator (1, 1') aus Metalloxid-Keramik, insbesondere $BaO$-$PbO$-$Nd_2O_3$-$TiO_2$, Metalltitanaten,

vorzugsweise Zinntitanat oder Zirkontitanat, Mischoxiden, die neben Barium als weiteres Metall Zirkon, Zinn oder Tantal enthalten, oder $MgTiO_3$-$CaTiO_3$ besteht.

11. Vorrichtung nach einem der vorhergehenden Ansprüche, **dadurch gekennzeichnet**, daß neben den beiden HF-Resonatoren (8, 8') eine baugleiche Gruppe von zwei weiteren HF-Resonatoren vorgesehen ist, die in gleicher Weise wie die zwei HF-Resonatoren (8, 8') mit der HF-Sendeeinrichtung und der Steuer- und Auswerteeinrichtung verbunden sind und unabhängig von den beiden HF-Resonatoren auf ein Bezugsmedium ausrichtbar sind.

12. Verfahren zur Messung der komplexen Dielektrizitätskonstante eines Stoffes durch Auswertung der durch die Anwesenheit des Stoffes verursachten Verstimmung eines HF-Resonators, wobei hochfrequente elektromagnetischer Felder mit auswählbarer Frequenz in den HF-Resonator eingekoppelt werden, das Resonatorfeld über eine Empfangseinrichtung aufgenommen wird und mit einer Meßschaltung die Amplitude der empfangenen Hochfrequenzsignale bestimmt wird, **dadurch gekennzeichnet**,
   - daß zwei HF-Resonatoren (8, 8'), die jeweils einen dielektrischen Festkörperresonator (1, 1') in einem Gehäuse mit einem ersten Abschnitt (2, 2'), welcher den Festkörperresonator wenigstens in einer Hemisphäre mit leitfähigem Material umschließt, und mit einem zweiten Abschnitt (3, 3'), der für elektromagnetische Wechsfelder durchlässig ist, aufweisen, so auf den zu messenden Stoff gerichtet werden, daß ihre zweiten Gehäuseabschnitte (3, 3') dem Stoff (10) zugewandt sind und ihre ersten Gehäuseabschnitte (2, 2') eine direkte Beeinflussung der HF-Resonatoren untereinander durch die aus den zweiten Gehäuseabschnitten austretenden HF-Felder abschirmen,
   - daß der erste bzw. zweite HF-Resonator mittels einer Einrichtung zum Abstimmen auf eine erste Resonzfrequenz ($\omega_{01}$) bzw. zweite, von der ersten Resonzfrequenz ($\omega_{01}$) verschiedene Resonanzfreqenz ($\omega_{02}$) bei Abwesenheit des zu messenden Stoffes eingestellt wird, und in beide HF-Resonatoren HF-Felder mit einer mittleren Frequenz ($\omega$) eingekoppelt werden, die in der Mitte zwischen der ersten ($\omega_{01}$) und der zweiten Resonanzfreqenz ($\omega_{02}$) liegt, und
   - daß die gemessenen Amplituden der jeweils in den beiden HF-Resonatoren empfangenen HF-Signale von einer Steuer- und Auswerteeinheit aufgenommen werden, und auf Grundlage von deren Summen- und Differenzwerten in der Steuer- und Auswerteeinheit mittels vorgegebener Abhängigkeiten die Dielektrizitätskonstante des zu messenden Stoffes bestimmt wird.

13. Verfahren nach Anspruch 12, **dadurch gekennzeichnet**, daß als vorgegebene Abhängigkeit die Beziehungen:

$$\Delta \varepsilon' \propto \frac{F1 - F2}{F1_0 + F2_0}$$

$$\Delta \varepsilon'' \propto \frac{F1_0 + F2_0 - (F1 + F2)}{F1_0 + F2_0}$$

verwendet werden, wobei F1 bzw. F2 die Amplitude des empfangenen HF-Signals des ersten bzw. zweiten HF-Resonators ist, wenn diese auf den zu messenden Stoff gerichtet sind, und $F1_0$ bzw. $F2_0$ die Amplitude des ersten bzw. zweiten HF-Resonators in Abwesenheit des zu messenden Stoffes ist.

14. Verfahren nach Anspruch 12, **dadurch gekennzeichnet**, daß als vorgegebene Abhängigkeit eine experimentell ermittelte Eichkurve verwendet wird.

15. Verfahren nach einem der vorhergehenden Ansprüche, **dadurch gekennzeichnet**, daß neben den zwei Resonatoren (8, 8') eine zweite Gruppe von zwei baugleichen HF-Resonatoren, die mit der gleichen Betriebsfrequenz ($\omega$) versorgt werden und deren HF-Signale in gleicher Weise in der Steuer- und Auswerteeinheit ausgewertet werden, auf ein Bezugsmedium gerichtet wird und die Werte der zweite Gruppe in der Steuer- und Auswerteeinheit als Bezugsgrößen verwendet werden.

**16.** Verfahren nach Anspruch 15, **dadurch gekennzeichnet**, daß die zweite HF-Resonatorgruppe auf leeren Raum gerichtet wird.

**17.** Verfahren nach Anspruch 15, **dadurch gekennzeichnet**, daß die zweite HF-Resonatorgruppe auf eine trockene Probe des zu messenden Stoffes gerichtet wird.

**18.** Verfahren nach Anspruch 15, **dadurch gekennzeichnet**, daß die zweite HF-Resonatorgruppe auf eine Probe des zu messenden Stoffes mit bekannter Feuchtigkeit gerichtet wird.

**19.** Verfahren nach Anspruch 15, **dadurch gekennzeichnet**, daß die zweite HF-Resonatorgruppe auf eine dielektrische Schicht des zu messenden Stoffes mit bekannter Dicke gerichtet wird.

FIG.1

II

II

2

1

3

FIG.2

2

4a

4b

5a

5b

1

3

FIG. 3A

FIG. 3B

FIG. 3C

**FIG. 4**

FIG. 5

FIG. 6

17